(19) Europäisches Patentamt
European Patent Office
Office européen des brevets

(11) **EP 4 347 909 B1**

(12) **EUROPÄISCHE PATENTSCHRIFT**

(45) Veröffentlichungstag und Bekanntmachung des Hinweises auf die Patenterteilung:
**27.08.2025   Patentblatt 2025/35**

(21) Anmeldenummer: **22758424.0**

(22) Anmeldetag: **19.07.2022**

(51) Internationale Patentklassifikation (IPC):
*C23C 10/02* (2006.01)     *C23C 10/28* (2006.01)
*C23C 10/36* (2006.01)     *C23C 14/16* (2006.01)
*C23C 14/58* (2006.01)     *C23C 26/02* (2006.01)
*C23C 28/02* (2006.01)     *C23C 30/00* (2006.01)
*C25D 3/12* (2006.01)      *C21D 9/00* (2006.01)
*H01M 50/00* (2021.01)     *B32B 15/01* (2006.01)
*C21D 1/18* (2006.01)      *C22C 19/03* (2006.01)
*C22C 38/00* (2006.01)     *C25D 5/14* (2006.01)
*C25D 5/36* (2006.01)      *C25D 5/50* (2006.01)
*C25D 7/00* (2006.01)      *H01M 8/00* (2016.01)

(52) Gemeinsame Patentklassifikation (CPC):
**C23C 28/02; B32B 15/015; C21D 1/18;
C22C 19/03; C22C 38/00; C23C 10/02;
C23C 10/28; C23C 10/36; C23C 14/16;
C23C 14/5806; C23C 26/02; C23C 28/021;
C23C 28/023; C23C 28/028; C23C 30/00;**   (Forts.)

(86) Internationale Anmeldenummer:
**PCT/EP2022/070211**

(87) Internationale Veröffentlichungsnummer:
**WO 2023/001829 (26.01.2023 Gazette 2023/04)**

(54) **BAUTEIL MIT EINER INTEGRIERTEN NICKELDIFFUSIONSSCHICHT**

COMPONENT WITH AN INTEGRATED NICKEL DIFFUSION LAYER

ARTICLE AVEC UNE COUCHE DE DIFFUSION EN NICKEL INTÉGRÉE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität:  **20.07.2021   DE 102021118765**

(43) Veröffentlichungstag der Anmeldung:
**10.04.2024   Patentblatt 2024/15**

(73) Patentinhaber: **KAMAX Holding GmbH & Co. KG
35315 Homberg (Ohm) (DE)**

(72) Erfinder:
• **SOLIMANI, Ali
35043 Marburg (DE)**
• **DUTENHÖFNER, Dennis
35315 Homberg (Ohm) (DE)**

(74) Vertreter: **Müller Schupfner & Partner
Patent- und Rechtsanwaltspartnerschaft mbB (Muc)
Bavariaring 11
80336 München (DE)**

(56) Entgegenhaltungen:
EP-A1- 3 269 841     EP-A1- 3 647 444
US-A1- 2016 168 657  US-A1- 2021 028 415

**(Forts. nächste Seite)**

(52) Gemeinsame Patentklassifikation (CPC): (Forts.)
**C25D 5/14; C25D 5/50;** C21D 9/0093; C25D 3/12;
C25D 5/36; C25D 7/003; H01M 8/00; H01M 50/00

**Beschreibung**

Die Erfindung betrifft ein Bauteil mit einem Bestandteil aus Stahl, bei dem der Bestandteil mit einer Nickeldiffusionsschicht beschichtet ist, wobei das Bauteil ein Befestigungsmittel ist, wie eine Schraube oder eine Mutter.

Bauteile aus Metall, insbesondere hochfeste und ultrahochfeste Bauteile, sind anfällig für eine Wasserstoffversprödung. Die Wasserstoffversprödung wird durch das Eindringen von Wasserstoff in die Metallstruktur der Bauteile verursacht und führt bei Beanspruchung der Bauteile zur interkristallinen Rissbildung. Dieses Phänomen wird als wasserstoffinduzierte Spannungsrisskorrosion bezeichnet.

Die US 2016/0168657 A1 betrifft ein Verfahren zur Herstellung eines oberflächenbehandelten Stahlblechs für Batteriecontainer, umfassend ein erstes Verfahren zur Herstellung einer Eisen-Nickel-Legierungsplattierungsschicht auf zumindest einer Seite des Stahlblechs, ein zweites Verfahren zum Bilden einer Nickelplattierungsschicht auf der Eisen-Nickel-Legierungsplattierungsschicht; und ein drittes Verfahren zum Durchführen einer Wärmebehandlung nach dem Bilden der Nickelplattierungsschicht, um durch thermische Diffusion eine Eisen-Nickel-Legierungsschicht mit einer äußersten Oberfläche zu bilden, bei der der Gehalt an Fe-Atomen 12 bis 55 Atom-% auf einer äußersten Schicht beträgt.

Der vorliegenden Erfindung liegt die Aufgabe zugrunde, die Neigung zur wasserstoffinduzierten Spannungsrisskorrosion bei Bauteilen aus Stahl zu verringern, wobei das Bauteil ein Befestigungsmittel ist.

Diese Aufgabe wird gelöst mit einem Befestigungsmittel mit einem Bestandteil aus Stahl gemäß Anspruch 1 und einer Verwendung gemäß Anspruch 8. Weitere Merkmale, Ausführungsformen sowie Vorteile ergeben sich aus den Unteransprüchen, der Beschreibung sowie aus den Figuren.

Ein Aspekt der Erfindung kann ein Bauteil mit einem Bestandteil aus Stahl betreffen, wobei das Bauteil ein Befestigungsmittel ist, wobei der Bestandteil aus Stahl einen Gewindebereich aufweist und/oder ausbildet, wobei der Bestandteil zumindest teilweise, insbesondere im Gewindebereich, mit einer Nickeldiffusionsschicht beschichtet ist, wobei die Schichtdicke der Nickeldiffusionsschicht 5 - 300 $\mu$m beträgt, wobei die Nickeldiffusionsschicht einen Nickelanteil aufweist, bezogen auf das Gesamtgewicht der Nickeldiffusionsschicht, von 2 Gew.-% über dem Nickelanteil des Stahls bis zu einer Maximalkonzentration, wobei der Nickelanteil in der Nickeldiffusionsschicht in Richtung Oberfläche der Nickeldiffusionsschicht kontinuierlich von 2 Gew.-% über dem Nickelanteil des Stahls bis zur Maximalkonzentration zunimmt, und wobei die Maximalkonzentration 20 - 100 Gew.-% beträgt, wobei die Schichtdicke der Nickeldiffusionsschicht und der Nickelanteil gemäß der Beschreibung gemessen werden. Das

Befestigungsmittel ist zweckmäßigerweise eine Schraube, insbesondere eine hochfeste oder sogar eine ultrahochfeste Schraube, oder eine Mutter, insbesondere eine hochfeste oder sogar eine ultrahochfeste Mutter.

Beschrieben wird auch ein Verfahren zur Herstellung eines Bauteils mit einem Bestandteil aus Stahl, wobei das Bauteil ein Befestigungsmittel ist, umfassend die Schritte:

a) Bereitstellen eines Befestigungsmittels mit einem Bestandteil aus Stahl, wobei der Bestandteil (1) einen Gewindebereich und/oder Schaftbereich aufweist und/oder ausbildet,

b) Aufbringen einer Nickelschicht, umfassend $\geq$ 30 Gew.-% Nickel, bezogen auf das Gesamtgewicht der Nickelschicht, auf dem Bestandteil aus Stahl, insbesondere im Gewindebereich und/oder Schaftbereich, und anschließend

c) Erwärmen des Bestandteils und der Nickelschicht für mindestens 10 Minuten, bevorzugt für mindestens 20 Minuten, auf 750 bis 950 °C, wodurch eine Nickeldiffusionsschicht auf dem Bestandteil aus Stahl hergestellt wird.

Ein weiterer Aspekt der Erfindung betrifft die Verwendung des erfindungsgemäßen Befestigungsmittels zur Verminderung einer Wasserstoffversprödung.

Überraschenderweise wirkt die erfindungsgemäße Nickeldiffusionsschicht auf Bauteilen aus Stahl als ausgeprägte Barriere gegen das Eindringen von Wasserstoff durch Diffusion und erhöht dadurch die Resistenz der Bauteile gegen wasserstoffinduzierte Spannungskorrosion. Der Diffusionsprozess und damit die Ausbildung der Nickeldiffusionsschicht verbessert zudem die Haftung der Nickelschicht auf dem Stahl, da die Nickelschicht sozusagen mit dem Stahl des Bauteils verwächst. Gerade bei Befestigungsmitteln, welche meist eine hohe und auch häufig dynamische axiale Spannung aufweisen, ist das Verhindern einer wasserstoffinduzierten Spannungskorrosion besonders vorteilhaft und wünschenswert, denn diese Befestigungsmittel, welche beispielsweise Schrauben oder Muttern sein können, sind für viele Baugruppen essentiell. Beispielsweise kann daher das Versagen eines Befestigungsmittels, insbesondere einer hochfesten oder ultrahochfesten Schraube, drastische Folgen für Mensch oder Maschine haben, wie z.B. bei einer Motorkopfschraube, einer Brückenschraube, einer Zylinderkopfschraube, einer Fahrwerksschraube und/oder einer Batteriebefestigungsschraube. In anderen Worten kann die Erfindung auch ein Fahrzeug, einen Motor, insbesondere einen Zylinderkopf, eine Fahrwerksanordnung oder eine Batterieanordnung mit einem Bauteil, insbesondere einem Befestigungsmittel, mit der erfindungsgemäßen Nickeldiffusionsschicht oder ein Bauwerk, insbesondere wie eine Brücke, betreffen.

Zur Herstellung der Nickeldiffusionsschicht wird der Bestandteil aus Stahl, beispielsweise eine hochfeste oder ultrahochfeste Schraube, mit einer Nickelschicht beschichtet. Zur Beschichtung sind alle im Stand der Technik bekannten Verfahren geeignet, insbesondere das galvanische Beschichten oder das Beschichten durch PVD (physical vapor deposition). Alternativ oder zusätzlich bevorzugt kann das Beschichten auch durch Laser Melting und/oder Laser Metal Deposition erfolgen. Diese Verfahren erlauben insbesondere eine besonders kostengünstige Beschichtung. Desweitern kann das Beschichten jedoch auch mittels Auftragsschweißen erfolgen, welches auch als Cladding bezeichnet werden kann, um eine besonders mechanisch belastbare Beschichtung zu erreichen.

Im sich anschließenden Erwärmungsschritt diffundiert Nickel in das Eisengitter des Stahls und Eisen in die Nickelschicht. So entsteht eine Nickeldiffusionsschicht, die eine größere Dicke aufweist als die ursprüngliche Nickelschicht. Neben dem Eisen diffundieren selbstverständlich auch etwaige Legierungsbestandteile des Stahls in die Nickelschicht. Die Nickeldiffusionsschicht weist einen Konzentrationsgradienten auf, bei dem die Nickelkonzentration in Richtung der Oberfläche der Nickeldiffusionsschicht kontinuierlich zunimmt. Die Eisenkonzentration nimmt in Richtung der Oberfläche der Nickeldiffusionsschicht kontinuierlich ab. Ferner nimmt die Konzentration etwaiger Legierungsbestandteile des Stahls in Richtung der Oberfläche der Nickeldiffusionsschicht kontinuierlich ab. Die Oberfläche ist insbesondere diejenige Fläche, welche die Nickeldiffusionsschicht distal gegenüberliegend bzw. abgewandt zu dem Bestandteil aus Stahl begrenzt. Die Nickeldiffusionsschicht ist daher insbesondere distal gegenüberliegend zu dem Bestandteil aus Stahl durch die Oberfläche begrenzt. Diese Oberfläche kann dabei selbst wiederum beschichtet sein und/oder die Oberfläche kann beispielsweise eine freie Oberfläche sein, welche nicht beschichtet ist. In anderen Worten kann die Oberfläche frei liegend sein oder durch eine Beschichtung und/oder durch ein weiteres Bauteil bedeckt sein. Die Oberfläche ist daher insbesondere der Bereich bzw. die sich ergebende Grenzfläche, an welcher die Maximalkonzentration vorliegt.

Unter einem Bestandteil aus Stahl im Sinne der Erfindung kann insbesondere verstanden werden, dass zumindest ein Teil des Bauteils, also ein Volumenbereich, aus Stahl ausgebildet ist. Besonders bevorzugt ist es, wenn das Gewicht des Bauteils zu zumindest 80%, bevorzugt zu zumindest 90%, und besonders stark bevorzugt zu zumindest 95 %, aus Stahl besteht bzw. durch den Bestandteil aus Stahl ausgebildet ist. Hierdurch kann eine besonders gute mechanische Festigkeit des Bauteils, insbesondere des Befestigungsmittels, erreicht werden. Besonders bevorzugt ist es, um die mechanische Festigkeit zu steigern, wenn der Bestandteil aus Stahl einstückig ist. Unter "einstückig" kann insbesondere verstanden werden, dass zumindest der einstückige Teil in einem Urformprozess geschaffen worden ist und/oder zusammenhängend ist.

Die Nickeldiffusionsschicht ist im Sinne der Erfindung definiert als der Bereich des Bestandteils aus Stahl, der einen Nickelanteil aufweist, bezogen auf das Gesamtgewicht der Nickeldiffusionsschicht, von 2 Gew.-% über dem Nickelanteil des Stahls bis zu einer Maximalkonzentration, wobei die Maximalkonzentration 20 - 100 Gew.-% Nickel beträgt. Wenn beispielsweise der eingesetzte Stahl kein Nickel enthält, ist die Nickeldiffusionsschicht die Schicht, die einen Nickelanteil von 2 Gew.-% bis zur Maximalkonzentration an Nickel aufweist. An der Oberfläche der Nickeldiffusionsschicht kann reines Nickel vorliegen, d. h. die Maximalkonzentration beträgt dann 100 Gew.-%. In diesem Falle liegt für einen Stahl ohne Nickelanteil die Nickelkonzentration in der Nickeldiffusionsschicht zwischen 2 und 100 Gew.-%.

Wenn im oben genannten Fall bei der Diffusion das Eisen bis an die Oberfläche der ursprünglichen Nickelschicht diffundiert, liegt die Maximalkonzentration unter dem ursprünglichen Nickelanteil der Nickelschicht, beispielsweise unter 100 Gew.-%, wenn eine reine Nickelschicht aufgebracht wurde. Beispielsweise können es dann 98 Gew.-% sein. In diesem Fall weist die Nickeldiffusionsschicht einen Nickelanteil von 2 - 98 Gew.-% auf.

Wenn der Stahl des Bestandteils des Bauteils ein legierter Stahl mit einem Nickelanteil von beispielsweise 1 Gew.-% ist, so beträgt der Nickelanteil in der Nickeldiffusionsschicht 3 Gew.-% bis zur Maximalkonzentration. Ist die Maximalkonzentration an der Oberfläche 100 Gew.-%, liegt somit der Nickelanteil in der Nickeldiffusionsschicht bei 3 - 100 Gew.-%. Für den Fall einer Diffusion des Eisens und/oder anderer Legierungsbestandteile des Substrats bzw. des Stahlbestandteils bis an die Oberfläche während des Erwärmungsschritts und einer resultierenden Maximalkonzentration von 95 Gew.-% an der Oberfläche der Nickeldiffusionsschicht, beträgt der Nickelanteil in der Nickeldiffusionsschicht in diesem Fall 3 - 95 Gew.-%.

Unter "beschichtet" mit einer Nickeldiffusionsschicht wird im Sinne der Erfindung verstanden, dass der Bestandteil aus Stahl im Querschnitt außen eine Nickeldiffusionsschicht aufweist. Dies bedeutet insbesondere, dass der Bestandteil aus Stahl in zumindest eine Raumrichtung durch eine festhaftende Schicht aus formlosem Stoff berandet ist, welche eine Nickeldiffusionsschicht ist. Vorteilhafterweise kann das Beschichten dabei der DIN 8580 entsprechen - insbesondere in der am 1. Mai 2021 geltenden Fassung.

Die Schichtdicke der Nickeldiffusionsschicht hängt unter anderem von der Dicke der ursprünglich aufgebrachten Nickelschicht und der Dauer und Temperatur des Erwärmungsschritts ab. Die Dicke der Nickeldiffusionsschicht beträgt erfindungsgemäß 1 - 500 $\mu$m, bevorzugt 3 - 300 $\mu$m, besonders bevorzugt 5 - 150 $\mu$m, insbesondere 7 - 100 $\mu$m und am meisten bevorzugt 10 - 70 $\mu$m. Die geringeren Dicken der bevorzugten Ausführungsformen der Nickeldiffusionsschicht sind insbesondere bei passgenauen Bauteilen von Vorteil.

Unter der "Schichtdicke" der Nickelschicht und der Nickeldiffusionsschicht wird, sofern die Ober- oder Unterseite Unebenheiten aufweist, die mittlere Schichtdicke verstanden. Dazu werden mindestens drei Messungen der Schichtdicke vorgenommen, vorzugsweise 6 bis 8 Messungen, und das arithmetische Mittel der Messwerte ermittelt.

Die Maximalkonzentration des Nickels in der Nickeldiffusionsschicht beträgt 20 - 100 Gew.-%. Bevorzugt sind 40 - 100 Gew.-%, weiter bevorzugt 70 - 100 Gew.-%, besonders bevorzugt 70 - 99,5 Gew.-%, insbesondere 80 - 99,2 Gew.-% und am meisten bevorzugt 90 - 99,0 Gew.-%. Diese Maximalkonzentrationen des Nickels in der Nickeldiffusionsschicht führen zu einer besonders vorteilhaften Ausgestaltung in Hinblick auf eine Wasserstoffversprödung.

Der Nickelanteil in der Nickeldiffusionsschicht nimmt kontinuierlich in Richtung der Oberfläche der Nickeldiffusionsschicht zu. Die Zunahme erfolgt dabei von 2 Gew.-% oberhalb des Nickelanteils des Stahls bis hin zur Maximalkonzentration, beispielsweise 70 - 99,5 Gew.-%. Vorzugsweise nimmt der Nickelanteil in der Nickeldiffusionsschicht senkrecht in Richtung Oberfläche der Nickeldiffusionsschicht zu. Weiter ist es bevorzugt, dass der Nickelanteil in der Nickeldiffusionsschicht senkrecht in Richtung der Oberfläche der Nickeldiffusionsschicht kontinuierlich zunimmt.

Um die Oberfläche des Bauteils mit einem Bestandteil aus Stahl an den jeweiligen Einsatzzweck weiter anzupassen, ist es bevorzugt, dass auf die Nickeldiffusionsschicht eine weitere Schicht aufgebracht ist, insbesondere ausgewählt aus Nickelschicht, Korrosionsschutzschicht, Verschleißschutzschicht und Gleitschicht. Bevorzugt sind Phosphatschichten, Zink-Nickel-Schichten und Zinklamellen, insbesondere wenn das Bauteil ein Befestigungsmittel, vorteilhafterweise eine Schraube oder ein Bolzen, ist. Diese Schichten sind insbesondere im Hinblick auf die Verbesserung der Korrosionsbeständigkeit und/oder der Reibeigenschaften von Vorteil.

Vorteilhafterweise ist der Bestandteil aus Stahl in Bereichen mit erhöhter Kerbwirkung und/oder benachbarten Bereichen zu Bereichen mit erhöhter Kerbwirkung mit der Nickeldiffusionsschicht beschichtet, insbesondere in Bereichen eines Gewindes, unter einem Kopf, z.B. einer Schraube, Kerben oder Nuten. Bereiche mit einer erhöhter Kerbwirkung sind insbesondere Bereiche, welche einen Kerbwirkungsfaktor von mehr als 1,1 bevorzugt von mehr als 1,4, besonders bevorzugt von mehr als 1,9 und besonders stark bevorzugt von mehr als 2,1, aufweisen. In einem Bereich eines Gewindes, einer Nut oder unter einem (Schrauben-)Kopf bzw. im Übergang zum Schraubenkopf ist daher vorteilhafterweise ein Bereich mit erhöhter Kerbwirkung im Sinne der Erfindung zu sehen. Unter einem benachbarten Bereich zu einem Bereich mit erhöhter Kerbwirkung ist dabei ein Bereich zu sehen, welcher maximal 10 mm bevorzugt maximal 5 mm und besonders bevorzugt maximal 2 mm, von dem Bereich mit erhöhter Kerbwirkung beabstandet ist. Alternativ bevorzugt kann ein benachbarter Bereich zu einem Bereich mit erhöhter Kerbwirkung auch dann vorliegen, wenn dieser maximal 10%, bevorzugt maximal 5%, besonders bevorzugt maximal 2%, der größten Hauptabmessung des Bestandteils aus Stahl von dem Bereich mit erhöhter Kerbwirkung beabstandet ist.

Eine Nickelschicht im Sinne der vorliegenden Erfindung ist vorzugsweise eine Schicht , deren Nickelanteil, bezogen auf das Gesamtgewicht der Nickelschicht, ≥ 30 Gew.-% ist, weiter bevorzugt ≥ 50 Gew.-%, noch weiter bevorzugt ≥ 70 Gew.-%, insbesondere ≥ 90 Gew.-% und am meisten bevorzugt 100 Gew.-%.

Die Nickelschicht kann eine Nickellegierung umfassen, vorzugsweise eine Ni-Co-, Ni-Mn- und/oder Ni-Co-Mn-Legierung. In diesen Nickelschichten, die auch als Nickellegierungsschichten bezeichnet werden, ist der Nickelanteil, bezogen auf das Gesamtgewicht der Schicht, ≥ 30 Gew.-%, weiter bevorzugt ≥ 50 Gew.-%, noch weiter bevorzugt ≥ 70 Gew-%.

Der Stahl des Bestandteils des Bauteils kann ein hochlegierter Stahl oder ein niedriglegierter Stahl sein, wobei ein niedriglegierter Stahl bevorzugt ist. Alternativ oder zusätzlich bevorzugt kann der Stahl, insbesondere niedriglegierter Stahl, auch ein unlegierter Stahl sein. Unter einem niedriglegierten Stahl wird im Sinne der Erfindung ein Stahl verstanden, dessen Gesamtanteil an Legierungselementen 5 Gew.-% nicht überschreitet, insbesondere der Legierungselemente Cr, Mo, V, Ni, Mn, Al, B und Ti, bezogen auf das Gesamtgewicht des Stahls. Unter den Begriff niedriglegierter Stahl im Sinne der Erfindung fallen auch mikrolegierte Stähle. Ein hochlegierter Stahl ist im Sinne der Erfindung ein Stahl, dessen Gesamtanteil an Legierungsbestandteilen größer als 5 Gew.-% ist, insbesondere der Legierungselemente Cr, Mo, V, Ni, Mn, Al, B und Ti, bezogen auf das Gesamtgewicht des Stahls. Unter einem unlegierten Stahl wird im Sinne der Erfindung ein Stahl verstanden, der bis zu 0,8 Gew.-% Kohlenstoff und weniger als 1 Gew.-% Mangan enthält, bezogen auf das Gesamtgewicht des Stahls.

In einer bevorzugten Ausführungsform der Erfindung handelt es sich bei dem Stahl des Bestandteils des Bauteils um einen niedriglegierten Stahl mit einem Nickelanteil < 1 Gew.-%, bezogen auf das Gesamtgewicht des Bestandteils aus Stahl. Weiter ist der Stahl bevorzugt ein hochfester oder ultrahochfester Stahl. Der Vorteil von niedriglegiertem Stahl ist dabei, dass dieser besonders gut vergütet werden kann und gleichzeitig oder alternativ ein besonders hohes Maß an Festigkeit bereitstellen kann, sodass hier die durch die Erfindung erreichten Vorteile, insbesondere in Hinblick auf eine Wasserstoffversprödung, besonders gut realisiert werden können.

In einer bevorzugten Ausführungsform der Erfindung ist das Gefüge des Bestandteils aus Stahl im Bauteil zumindest überwiegend martensitisch, bainitisch und/oder dual-phasig (Restaustenit, Ferrit und/oder Martensit). Vorzugsweise ist das Gefüge des Bestandteils aus Stahl im Bauteil mindestens 80 Gew.-%, insbesondere mindestens 90 Gew.-% martensitisch, bainitisch und/oder dual-phasig (Restaustenit, Ferrit und/oder Martensit), jeweils bezogen auf das Gesamtgewicht des Bestandteils aus Stahl. Diese Gefüge verleihen dem erfindungsgemäßen Bauteil eine besonders hohe Festigkeit und Zähigkeit. Diese Gefüge können einer hohen und auch häufig dynamischen axialen Spannung ausgesetzt werden, so dass für sie die Verminderung der Wasserstoffversprödung besonders vorteilhaft ist. Das Gefüge in der Nickeldiffusionsschicht kann sich vom Gefüge des restlichen Bestandteils aus Stahl (des sogenannten Grundwerkstoffs) unterscheiden. Die Elementverteilung in der Nickeldiffusionsschicht ist vorteilhafterweise gekennzeichnet durch eine hohe Konzentration von zwei Elementen, nämlich Eisen und Nickel. Die anderen Legierungselemente können je nach Zusammensetzung des Bestandteils aus Stahl als gelöste Elemente oder als intermetallische Ausscheidung in der Nickeldiffusionsschicht vorliegen.

Das erfindungsgemäße Bauteil ist vorzugsweise ein hochfestes oder ultrahochfestes Bauteil, insbesondere mit Festigkeiten über 1000 MPa, bevorzugt über 1200 MPa, besonders bevorzugt über 1400 MPa und besonders stark bevorzugt über 1600 MPa. Bevorzugte hochfeste und ultrahochfeste Bauteile sind hochfeste oder ultrahochfeste Schrauben bzw. Befestigungsmittel, Federn, Blattfedern, Tellerfedern und Kettenantriebe, Umformbauteile und/oder Strukturbauteil. Weiter oder alternativ bevorzugt ist das erfindungsgemäße Bauteil, insbesondere das hochfeste oder ultrahochfeste Bauteil, bevorzugt ein geschweißtes Bauteil, ein additiv-gefertigtes Bauteil oder ein einsatzgehärtetes Bauteil. Gerade bei geschweißten Bauteilen kann eine hohe Wasserstoffversprödung durch das Schweißen entstehen, sodass gerade hier die Erfindung besonders gut eingesetzt werden kann. Bei einem einsatzgehärteten Bauteil wird zur Herstellung das Bauteil zusätzlich einsatzgehärtet, insbesondere durch Aufkohlung, Nitrierung oder Nitrocarburierung. Anschließend wird das Bauteil dann mit Nickel beschichtet, wie vorliegend beschrieben.

Unter einem umgeformten Bauteil ist insbesondere ein Bauteil zu verstehen, welches mittels eines Umformschrittes, insbesondere einem Kaltumformverfahren, umgeformt wurde. Gerade bei einem Umformbauteil, insbesondere einem kaltumgeformten Bauteil, ist eine Vermeidung einer Sprödigkeit, insbesondere einer Wasserstoffversprödung, besonders vorteilhaft, denn bei umgeformten Bauteil besteht bereits ein gewisses Maß an Sprödigkeit durch die aufgestauten Waldversetzungen. Ein Strukturbauteil im Sinne der Erfindung liegt insbesondere dann vor, wenn es sich bei dem Bauteil um ein lasttragendes Bauteil handelt. Dieses Strukturbauteil verfügt insbesondere über zwei Lasteinleitungsabschnitte, welche vorteilhafterweise lasteinleitende Strukturen, wie z.B. Montageausnehmungen oder -durchbrüche, aufweisen, und einen zwischen den Lasteinleitungsabschnitten angeordneten Übertragungsbereich, welcher eine Last, insbesondere eine Biegelast und/oder Zuglast, von dem einem Lasteinleitungsabschnitt auf den anderen Lasteinleitungsabschnitt übertragen kann und/oder überträgt. Vorteilhafterweise ist dabei zumindest einer, bevorzugt alle Lasteinleitungsabschnitte, und/oder der Übertragungsbereich mit der erfindungsgemäßen Nickeldiffusionsschicht ausgestattet. Das Ausbilden des Bauteils dahingehend, dass der Stahl eine Festigkeit von über 1000 MPa, bevorzugt über 1200 MPa, besonders bevorzugt über 1400 MPa und besonders stark bevorzugt über 1600 MPa, aufweist, ist gerade besonders vorteilhaft, da bei diesen Festigkeitsklassen die Wasserstoffversprödung immer entscheidender wird, sodass die Erfindung ihre Vorteile gerade bei diesen Festigkeiten ausspielen kann.

Die erfindungsgemäßen Befestigungsmittel können insbesondere kraftschlüssige Befestigungsmittel sein, wie Schrauben, Bolzen oder Muttern. Kraftschlüssige Befestigungsmittel zeichnen sich insbesondere dadurch aus, dass diese einen Gewindeabschnitt zum Verspannen oder Befestigen aufweisen, insbesondere mit einem Außengewinde oder einem Innengewinde. Beispielsweise kann der Gewindeabschnitt daher ein Außengewinde oder ein Innengewinde sein. Vorteilhafterweise ist dieser Gewindeabschnitt dabei in einem Bestandteil des Befestigungsmittels eingebracht, welcher aus Stahl ist. In anderen Worten kann der Bestandteil aus Stahl einen Gewindeabschnitt aufweisen, welcher mit der vorgehend und nachfolgend dargelegten Nickeldiffusionsschicht beschichtet sein kann. Zweckmäßigerweise sind insbesondere zumindest drei, bevorzugt zumindest fünf, und besonders bevorzugt alle Gewindegänge, des Gewindeabschnitts mit der Nickeldiffusionsschicht beschichtet. Vorteilhafterweise sind zumindest die distalen Endgewindegänge dabei diejenigen Gewindegänge, welche mit der Nickeldiffusionsschicht beschichtet sind. Die Endgewindegänge sind dabei insbesondere die Gewindegänge, welche ein Ende des Gewindeabschnitts ausbilden oder die Endbereiche des Gewindeabschnitts oder den Gewindeauslauf ausbilden. Alternativ oder zusätzlich bevorzugt kann die Nickeldiffusionsschicht auch in einem Schaftbereich vorhanden sein. Der Schaftbereich ist insbesondere ein Bereich des Befestigungsmittels, welcher zwischen dem Kopf, insbesondere dem Schraubenkopf, und dem Gewindeabschnitt des Befestigungsmittels liegt und diese mechanisch miteinander verbindet. Vorzugsweise kann der Schaftbereich gewindelos ausgebildet sein und/oder als ein zylindrischer Abschnitt ausgebildet sein. Der Durchmesser des Schafts kann dabei größer, geringer oder gleich dem Gewindedurchmesser im Gewindeabschnitt sein. Durch das Aufbringen bzw. Ausbilden einer Nickeldiffusionsschicht - wie vorgehend und nachfolgend beschrieben - in dem Schaftbereich können dort die mechanischen Eigenschaften des Befestigungsmittels erfindungsgemäß positiv beeinflusst werden. Bei den Schrauben handelt es sich vorteilhafterweise um hochfeste oder ultrahochfeste Schrauben.

Der Bestandteil aus Stahl in dem erfindungsgemäßen Bauteil ist zumindest teilweise mit einer Nickeldiffusionsschicht beschichtet, das heißt der Bestandteil ist teilweise oder vollständig mit einer Nickeldiffusionsschicht beschichtet.

In einer besonders bevorzugten Ausführungsform der Erfindung ist das Bauteil eine hochfeste oder ultrahochfeste Schraube. Unter einer hochfesten Schraube wird eine Schraube mit einer Zugfestigkeit von mindestens 800 MPa verstanden. Hochfeste Schrauben sind beispielsweise Schrauben der Festigkeitsklassen 8.8, 10.9 und 12.9. Insbesondere entsprechen die Festigkeitsklassen der Erfindung dabei der ISO 898-1 in ihrer im Januar 2021 gültigen Fassung. Unter einer ultrahochfesten Schraube wird eine Schraube mit einer Zugfestigkeit insbesondere von mindestens 1200 MPa und/oder vorteilhafterweise von 1400 MPa verstanden. Ultrahochfeste Schrauben sind beispielsweise Schrauben der Festigkeitsklassen 12.8, 12.9, 14.8, 14.9, 15.8, 15.9, 16.8, 16.9, 17.8 und 12.8U, 12.9U, 14.8U, 14.9U, 15.8U, 15.9U, 16.8U, 17.8U. Eine hochfeste Schraube ist eine Schraube, die mindestens hochfest ist, sie kann aber auch ultrahochfest sein. Vorzugsweise handelt es sich um eine hochfeste oder ultrahochfeste Schraube mit einer Festigkeit über 1000 MPa. Besonders bevorzugt ist dabei der Bestandteil des Bauteils bzw. der Schraube, welche(r) die Nickeldiffusionsschicht aufweist, der Schaft und/oder der Gewindebereich der Schraube, denn gerade hier treten starke dynamische Lasten im Betrieb der Schraube auf, welche die Anfälligkeit der Schraube gegenüber Wasserstoffversprödung erhöhen, welche durch die Erfindung verhindert oder zumindest deutlich reduziert werden kann. Die Schraube kann dabei einen Kopf mit Werkzeugangriffsflächen aufweisen, wobei diese Werkzeugangriffsflächen insbesondere einen Innen- oder einen Außensechskant miteinander ausbilden. Besonders bevorzugt ist es, wenn die gesamte Schraube mit der Nickeldiffusionsschicht beschichtet ist.

In einer bevorzugten Ausführungsform der Erfindung ist das Bauteil mit einem Bestandteil aus Stahl ein Befestigungsmittel, wobei der Bestandteil einen Gewindebereich und/oder einen Schaftbereich aufweist und/oder ausbildet, wobei der Bestandteil zumindest teilweise mit einer Nickeldiffusionsschicht beschichtet ist, insbesondere im Gewindebereich und/oder im Schaftbereich, wobei die Schichtdicke der Nickeldiffusionsschicht 1 - 500 $\mu$m beträgt, wobei die Nickeldiffusionsschicht einen Nickelanteil aufweist, bezogen auf das Gesamtgewicht der Nickeldiffusionsschicht, von 2 Gew.-% über dem Nickelanteil des Stahls bis zu einer Maximalkonzentration, wobei der Nickelanteil in der Nickeldiffusionsschicht in Richtung Oberfläche der Nickeldiffusionsschicht kontinuierlich von 2 Gew.-% über dem Nickelanteil des Stahls bis zur Maximalkonzentration zunimmt, und wobei die Maximalkonzentration 20 - 100 Gew.-% beträgt, vorzugsweise 40 - 100 Gew.-%, vorzugsweise wobei der Stahl ein niedriglegierter Stahl oder ein unlegierter Stahl ist.

Wie oben beschrieben ist das Befestigungsmittel vorzugsweise ein hochfestes oder ultrahochfestes Befestigungsmittel, insbesondere eine Schraube oder Mutter.

Beschrieben wird auch ein Verfahren zur Herstellung des erfindungsgemäßen Bauteils. Das erfindungsgemäße Verfahren umfasst die Schritte:

    a) Bereitstellen eines Bauteils, wobei das Bauteil ein Befestigungsmittel ist, mit einem Bestandteil aus Stahl,

    b) Aufbringen einer Nickelschicht, umfassend $\geq$ 30 Gew.-% Nickel, bezogen auf das Gesamtgewicht der Nickelschicht, auf dem Bestandteil aus Stahl, und

    c) Erwärmen des Bestandteils und der Nickelschicht für mindestens 20 Minuten auf 750 bis 950 °C, wodurch eine Nickeldiffusionsschicht auf dem Bestandteil aus Stahl hergestellt wird.

Die oben genannten Schritte a), b) und c) werden in dieser Reihenfolge durchgeführt. Wie oben beschrieben hängt die Schichtdicke der Nickeldiffusionsschicht unter anderem von der Dicke der ursprünglich aufgebrachten Nickelschicht und der Dauer und Temperatur des Erwärmungsschritts ab. Die im Schritt b) aufgebrachte Nickelschicht hat vorzugsweise eine Dicke von 0,1 - 100 Mikrometer ($\mu$m), weiter bevorzugt 0,5 - 80 $\mu$m, noch weiter bevorzugt 1 - 50 $\mu$m, besonders bevorzugt 1,5 - 30 $\mu$m, insbesondere 2,5 - 15 $\mu$m.

Vorzugsweise wird im Erwärmungsschritt für mindestens 10 Minuten erwärmt, bevorzugt mindestens 15 Minuten und besonders bevorzugt für mindestens 20 Minuten. Weiter ist es bevorzugt, dass die Erwärmung für 10 - 600 Minuten stattfindet, besonders bevorzugt für 15 - 400 Minuten und am meisten bevorzugt für 20 - 180 Minuten erwärmt wird. Die Erwärmung erfolgt auf 750 - 950 °C für die angegebenen Zeiträume, vorzugsweise auf 800 - 950 °C, besonders bevorzugt auf 820 - 920 °C, insbesondere auf 830 - 900 °C. So wird eine vorteilhafte Interdiffusion zwischen Eisen und Nickel zur Ausbildung der Nickeldiffusionsschicht erreicht, die der Wasserstoffversprödung entgegenwirkt.

Nach dem Erwärmungsschritt c) können sich weitere Schritte anschließen, insbesondere ein Vergütungsschritt d). Alternativ oder zusätzlich bevorzugt kann der Vergütungsschritt jedoch auch während und/oder zeitgleich bzw. zusammen mit dem Erwärmungsschritt c) erfolgen. In anderen Worten kann das Vergüten und das Erwärmen in einem Schritt gemeinsam erfolgen. Hierdurch kann eine besonders schnelle und kostengünstige Erstellung der Nickeldiffusionsschicht, insbesondere bei einem niedriglegierten Stahl, erreicht werden. Beispielsweise kann ein martensitisches Vergüten (vorzugsweise durch Abschrecken in Öl, Luft und/oder Wasser) oder eine Bainitisierung (vorzugsweise im Salzbad) erfolgen. Ein martensitisches Vergüten oder eine Bainitisierung erfolgen unter den üblichen Bedingungen.

Der Erwärmungsschritt c) kann somit ein separat vorgenommener Erwärmungsschritt sein, beispielsweise in einem Ofen, oder der Erwärmungsschritt kann während des Vergütungsschritts des Bauteils stattfinden, beispielsweise bei der Austenitisierung des Stahls. Vorzugsweise findet der Erwärmungsschritt während des Vergütens des Bauteils statt.

Beschrieben wird auch ein Verfahren zur Herstellung eines Bauteils die Schritte:

    a) Bereitstellen eines Bauteils mit einem Bestandteil aus Stahl, wobei das Bauteil ein Befestigungsmittel ist und der Bestandteil einen Gewindebereich und/oder Schaftbereich aufweist und/oder ausbildet, wobei der Stahl ein niedriglegierter Stahl oder ein unlegierter Stahl ist,

    b) Aufbringen einer Nickelschicht, umfassend 40 - 100 Gew.-% Nickel, bezogen auf das Gesamtgewicht der Nickelschicht, auf dem Bestandteil aus Stahl, insbesondere im Gewindebereich und/oder Schaftbereich, und

c) Erwärmen des Bestandteils und der Nickelschicht für mindestens 10 Minuten, bevorzugt zumindest 20 Minuten, auf 750 bis 950 °C, wodurch eine Nickeldiffusionsschicht auf dem Bestandteil aus Stahl hergestellt wird.

In dem Verfahren sind die bevorzugten und besonders bevorzugten Merkmale des Bauteils ebenfalls bevorzugt und besonders bevorzugt.

Die Erfindung betrifft auch die Verwendung des erfindungsgemäßen Befestigungsmittels zur Vermeidung oder Verminderung einer Wasserstoffversprödung. Die Verwendung umfasst vorzugsweise die Verwendung der beschriebenen, bevorzugten Bauteile zur Vermeidung oder Verminderung einer Wasserstoffversprödung, beispielsweise eines Befestigungsmittels mit einem Gewindebereich. Dies betrifft insbesondere die Verminderung oder Vermeidung der Wasserstoffversprödung in dem Bauteil durch Wasserstoff, der von außen eindringen kann, beispielsweise beim bestimmungsgemäßen Gebrauch des Bauteils. Dies kann zum Beispiel beim Einsatz des erfindungsgemäßen Bauteils, beispielsweise eines Befestigungsmittels, in einem korrosiven Umfeld der Fall sein. Die erfindungsgemäße Nickeldiffusionsschicht schützt dann besonders wirksam das Bauteil vor einer Wasserstoffversprödung, indem sie das Eindringen des Wasserstoffs in das Bauteil vermindert oder verhindert.

Eine bevorzugte Ausführungsform der Erfindung betrifft die Verwendung des erfindungsgemäßen Befestigungsmittels in einer Batterieanordnung oder einer Brennstoffzelle. Bei Batterien oder Brennstoffzellen entsteht häufig relativ viel Wasserstoff und hier kann die erfindungsgemäße Nickeldiffusionsschicht mit besonderem Vorteil die Wasserstoffversprödung vermeiden.

Die Erfindung betrifft auch eine Batterieanordnung und/oder Brennstoffzelle, umfassend ein erfindungsgemäßes Befestigungsmittel, insbesondere ein erfindungsgemäßes Befestigungsmittel. Hier werden die oben beschriebenen Vorteile der Vermeidung einer Wasserstoffversprödung besonders wirksam erreicht aufgrund der relativ hohen Mengen an Wasserstoff, die in Batterieanordnungen oder Brennstoffzellen entstehen.

Die oben beschriebenen, vorteilhaften Ausgestaltungen des Verfahrens sind auch für dieses bevorzugte Verfahren vorteilhaft, insbesondere die erwähnten bevorzugten und besonders bevorzugten Schichtdicken, Temperaturen, Erwärmungsdauern und/oder vorteilhaften Bauteile etc.

Das Gefüge des Bestandteils aus Stahl kann vor dem Erwärmungsschritt c) ferritisch, ferritisch-perlitisch, bainitisch, GKZ-geglüht oder ein Mischgefüge sein. Nach dem Vergütungsschritt d) kann das Gefüge des Bestandteils in einer bevorzugten Ausführungsform martensitisch, bainitisch oder ferritisch-martensitisch oder dual-phasig (Restaustenit, Ferrit und/oder Martensit) sein.

Es versteht sich, dass die vorstehend genannten und die nachstehend noch zu erläuternden Merkmale nicht nur in den angegebenen Kombinationen, sondern auch in anderen Kombinationen oder in Alleinstellung einsetzbar sind, ohne den Rahmen der vorliegenden Erfindung zu verlassen. Die genannten Vorteile von Merkmalen oder von Kombinationen mehrerer Merkmale sind lediglich beispielhaft und können alternativ oder kumulativ zur Wirkung kommen. Die Kombination von Merkmalen unterschiedlicher Ausführungsformen der Erfindung oder von Merkmalen von unterschiedlichen Patentansprüchen ist abweichend von den gewählten Rückbezügen der Patentansprüche möglich.

Das nachfolgende Beispiel erläutert die Erfindung weiter.

Messmethode zur Schichtdickenbestimmung:

Die Schichtdicke der Nickelschicht wird vorzugsweise mit einem Mikrometer gemessen, beispielsweise mit Hilfe des Verfahrens gemäß ASTM C664-10 (in der Fassung wie veröffentlicht 2020, Testmethode A). Dazu wird im Wesentlichen die Dicke des Bauteils vor und nach der Beschichtung gemessen und aus der Differenz ergibt sich die Schichtdicke.

Die Dicke der Nickeldiffusionsschicht kann ermittelt werden, indem zunächst die Dicke des Bauteils gemessen wird, nach dem Beschichten mit der Nickelschicht und der Ausbildung der Nickeldiffusionsschicht durch den Erwärmungsschritt. Anschließend wird die Nickeldiffusionsschicht abgetragen, beispielsweise durch Schleifen, und die Zusammensetzung des Materials analysiert, zum Beispiel durch chemische Analyse des abgetragenen Materials oder chemische Analyse des verbleibenden Oberflächenmaterials. Als Analysemethode können beispielsweise nasschemische Verfahren oder die Rasterkraftmikroskopie (AFM) eingesetzt werden. Es wird so lange Material abgetragen, wie das abgetragene Material einen Nickelanteil von mindestens 2 Gew.-% über dem Nickelanteil des Stahls aufweist, bezogen auf das Gesamtgewicht der Nickeldiffusionsschicht. Nach Abtragung der Nickeldiffusionsschicht ist der Nickelanteil des Stahls auf der Oberfläche des Bauteils knapp unterhalb von 2 Gew.-% über dem Nickelanteil des Stahls und es wird erneut die Dicke des Bauteils mit einem Mikrometer gemessen. Aus der Differenz ergibt sich die Dicke der Nickeldiffusionsschicht.

Alternativ kann die Schichtdicke der Nickeldiffusionsschicht mit Hilfe des Verfahrens gemäß ASTM C664-10 (in der Fassung wie veröffentlicht 2020, Testmethode B) ermittelt werden. Dazu wird im Wesentlichen im Querschliff die Schichtdicke mit Hilfe eines optischen Mikroskops bestimmt. Ferner ist es möglich, die Schichtdicke der Nickeldiffusionsschicht im Querschliff mit Hilfe der Energiedispersiven Röntgenspektroskopie (EDS, EDX, EDXS oder XEDS) zu bestimmen.

Beispiel:

Herstellung einer Nickeldiffusionsschicht und Einfluss auf die wasserstoffinduzierte Spannungsrisskorrosion Die Herstellung eines Bauteils mit Nickeldiffusionsschicht erfolgt durch die Herstellung des Bauteils aus dem Substratwerkstoff Stahl mittels axialer Kaltmassivumformung. Das Ausgangsmaterial wird dabei der Umformmaschine in Form einer Drahtspule zugeführt. Das umgeformte Produkt besitzt die Geometrie einer Schraube. Im Anschluss daran erfolgt eine Reinigung in einer Natriumhydroxid-Lösung und inhibierter HCl, um das zur Umformung benötigte Schmiermittel (Phosphat) zu entfernen, damit die Diffusion des Phosphors bei späterer Wärmebehandlung in das Substrat verhindert wird. Es erfolgt eine Aktivierung der Oberfläche mittels 10%iger Schwefelsäure. Im Anschluss wird eine Nickelschicht durch galvanische Abscheidung mit Hilfe eines üblichen Nickelbades aufgebracht (55°C für 15 min, Stromdichte 0,8 - 1 A/dm$^2$). Es wird eine Ni-Schicht von 2-3 $\mu$m erzeugt (Bestimmung gemäß oben beschriebener Methode). Danach erfolgt ein Spülen in VE-Wasser und eine Trocknung.

Vor der Nickelschicht kann zur besseren Haftung auch zusätzlich eine <1$\mu$m dicke Nickelschickt aufgebracht werden, z.B. im sog. Ni-Strike Verfahren.

Nach dem Aufbringen der Beschichtung wird das Bauteil zur Vergütung auf einer Temperatur von 850°C für 30 min. in einer Schutzgasatmosphäre austenitisiert. Während dieser Zeit kommt es zur Interdiffusion des Nickels in den Substratwerkstoff und umgekehrt. Es bildet sich eine Zone aus, die einen Gradienten der Konzentration von Nickels aufweist. Zur Einstellung des gewünschten Gefüges und der mechanischen Eigenschaften des Bauteils wird unmittelbar nach dem Austenitisieren ein Abschrecken durchgeführt. Während des Abschreckvorgangs wird eine geeignete Gefügestruktur eingestellt. Innerhalb der Diffusionsschicht wandelt der erzeugte Werkstoff gemäß seiner lokal vorliegenden Ni-Konzentration um. Das resultierende Bauteil verfügte über eine Zugfestigkeit von 1600 MPa - 1650 MPa.

Experimentelle Beurteilung des Einflusses der Nickeldiffusionsschicht auf wasserstoffinduzierte Spannungsrisskorrosion:

Das Phänomen wasserstoffinduzierter Spannungsrisskorrosion bei höherfesten Stahlwerkstoffen erfordert im Allgemeinen drei äußere Einflussfaktoren. Diese sind:

1. Werkstoff mit einer Anfälligkeit auf wasserstoffinduzierte Spannungsrisskorrosion
2. Hohe mechanische Zug- oder Biegespannungen im Bauteil
3. Wasserstoffangebot in der Umgebung

Zur Bewertung des Werkstoffverhaltens hinsichtlich wasserstoffinduzierter Spannungsrisskorrosion eignet sich daher ein Versuchsaufbau, bei dem die beiden übrigen Faktoren reproduzierbar abgebildet werden. Zur Beurteilung wird daher der Prüfaufbau nach DIN EN ISO 7539-7 verwendet.

Als besonders präzise hat sich hierbei die Auswertung gemäß DIN EN ISO 7539-7 Kapitel 7.3 nach "Integral der Nennspannungs-/Dehnungs-Kurve" erwiesen. In jedem Fall wird zur Charakterisierung immer das System bestehend aus o.g. Einflussfaktoren im Zustand ohne Wasserstoffangebot in der Umgebung mit dem System mit Wasserstoffangebot in der Umgebung verglichen. Nach der Auswertung des Kennwerts des "Integral der Nennspannungs-/Dehnungs-Kurve", ergibt sich für jeden der beiden Zustände ein Wert für die Gesamte durch das Bauteil aufgenommene Verformungsenergie. Mittels der Formel

$$\mathrm{HE} = 1 - \frac{\mathrm{W_{Bh}}\ (\textit{Verformungsenergie mit}\ \mathrm{H} - \textit{Beladung})}{\mathrm{W_{Bu}}\ (\textit{Verformungsenergie ohne}\ \mathrm{H} - \textit{Beladung})}$$

wird aus den beiden ermittelten Verformungsenergien der sogenannte HE-Wert bestimmt. Der HE-Wert kann zwischen 0 und 1 liegen. Dabei bedeutet ein Wert von HE=0 keine Beeinflussung der Werkstoffeigenschaften, während HE=1 das Versagen unter Wasserstoff ohne Belastung bedeutet (letzterer ist ein theoretischer Extremwert und in der Realität nicht möglich). Die Integrale der Nennspannungs-/Dehnungs-Kurve für $W_{Bh}$ und $W_{Bu}$ sind für o.g. Schraubenbauteile schematisch in Fig: 2 gezeigt.

Benötigtes Material zur Testdurchführung:

1. Bauteile im zu prüfenden Zustand
2. 37% HCl
3. VE-Wasser
4. Instrumentierte Zug-/Druckprüfmaschine

Die Durchführung des Versuchs zur Charakterisierung der Schrauben mit integrierter Nickeldiffusionsschicht erfolgt indem der Referenzwert ohne Wasserstoffbelastung $W_{Bu}$ bestimmt wird. Dieser wird anhand des Mittelwerts dreier Proben mit einer Dehnungsgeschwindigkeit von 0,0067 1/s in der instrumentierten Zug-/Druckprüfmaschine ermittelt. Es konnte $W_{Bu}$=268 J ermittelt werden.

Zur Ermittlung der Verformungsenergie unter Einfluss von Wasserstoff $W_{Bh}$ wurden drei Proben identischer Fertigungscharge wie oben für 10 min. in 37% HCl ausgelagert, um durch die kathodische Teilreaktion der Säurekorrosion Wasserstoff einzutragen. Unmittelbar im Anschluss wurden die so behandelten Proben bei einer Elongationsgeschwindigkeit von 0,02 mm/min. (Gesamtversuchsdauer 4h) in der instrumentierten Zug-/Druckprüfmaschine geprüft, um $W_{Bh}$ zu ermitteln. Es konnte $W_{Bh}$ = 246 J ermittelt werden.

Insgesamt wurde folglich eine Anfälligkeit gegenüber wasserstoffinduzierte Spannungsrisskorrosion von HE=0,08 ermittelt.

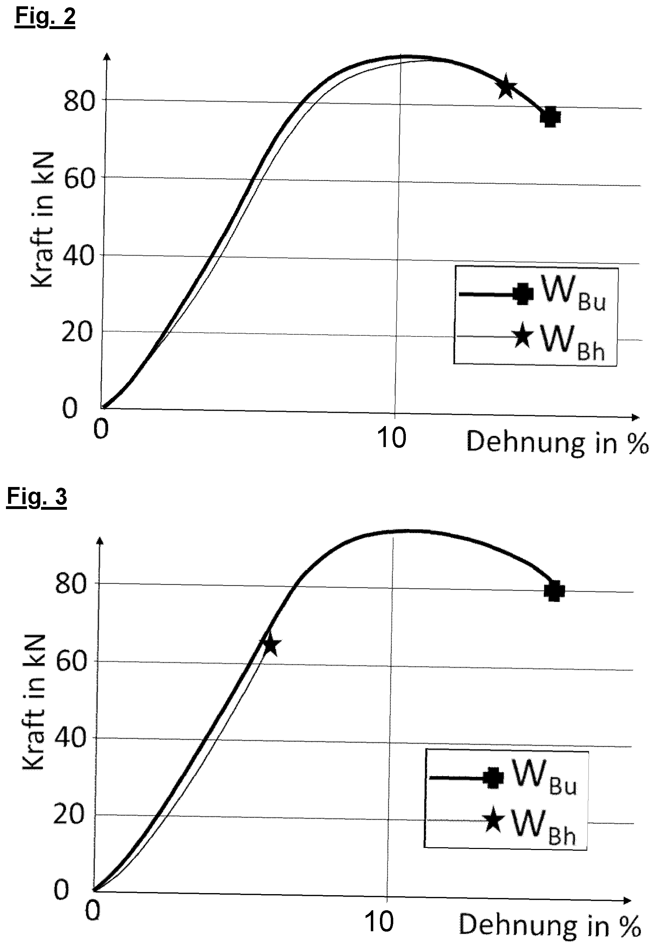

In den Fig. 2 und 3 ist der Vergleich zwischen den bekannten Bauteilen und dem erfindungsgemäßen Bauteil mit integrierter Nickeldiffusionsschicht gezeigt.

Weitere Vorteile und Merkmal der vorliegenden Erfindung ergeben sich aus der nachfolgenden Beschreibung mit Bezug auf die Figuren. Einzelne Merkmale der dargestellten Ausführungsformen können dabei auch in anderen Ausführungsformen eigesetzt werden, sofern dies nicht ausdrücklich ausgeschlossen wurde. Es zeigt:

Figur 1   ein erfindungsgemäßes Bauteil;
Figur 2   ein Zug-Dehnungsdiagramm bei einer erfindungsgemäßen Vorrichtung; und
Figur 3   ein Zug-Dehnungsdiagramm bei nicht erfindungsgemäßen Vorrichtung;

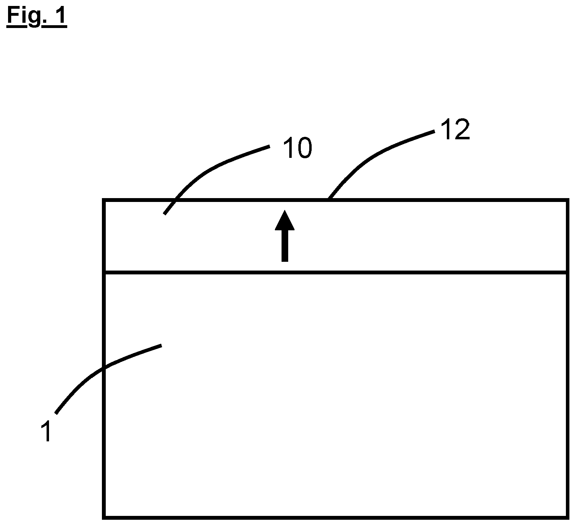

In der **Figur** 1 ist ein erfindungsgemäßes Bauteil gezeigt. Das Bauteil verfügt über einen Bestandteil 1 aus Stahl. Das Bauteil kann dabei insbesondere ein Befestigungsmittel sein oder eine Feder. Der Bestandteil 1 ist zumindest teilweise mit einer Nickeldiffusionsschicht 10 beschichtet, wobei die Schichtdicke der Nickeldiffusionsschicht 1 bis 500 $\mu$m beträgt. Der Pfeil in der Nickeldiffusionsschicht 10 der Figur 1 zeigt dabei die Abnahme der Konzentration des Nickels in der Nickeldiffusionsschicht 10 sowie die Dickenrichtung an, in welche sich insbesondere die Dicke der Nickeldiffusionsschicht 10 bestimmen kann. Die Nickeldiffusionsschicht ist dabei distal gegenüberliegend zu dem Bestandteil 1 aus Stahl durch die Oberfläche 12 begrenzt. Diese Oberfläche 12 kann dabei selbst wiederum beschichtet sein.

In der **Figur** 2 ist ein Zug-Dehnungsdiagramm gezeigt, welches sich bei einem erfindungsgemäßen Produkt ergeben bzw. einer erfindungsgemäßen Vorrichtung ergeben hat. In dem Diagramm ist dabei die Nennspannung - in Figur 2 in MPa angegeben - über der Dehnung (%) aufgetragen. Aus diesem Zug-Dehnungsdiagramm kann der HE-Wert bestimmt werden bzw. es kann die aufgenommene (spezifische) Verformungsenergie bestimmt werden.

Der HE-Wert berechnet sich dabei nach der Formel:

$$HE = 1 - \frac{W_{Bh}\ (\text{Verformungsenergie mit H} - Beladung)}{W_{Bu}\ (\text{Verformungsenergie ohne H} - Beladung)}$$

Der $W_{Bh}$ Wert ist dabei die aufgenommene (spezifische) Verformungsenergie des Bauteils, wobei das Bauteil mit Wasserstoff behandelt wurde. Der Der $W_{Bu}$ Wert hingegen ist dabei die aufgenommene Verformungsenergie, wobei das Bauteil nicht mit Wasserstoffbehandelt wurde. Wie der Figur 2 schematisch entnommen werden kann, ist die aufgenommene Verformungsenergie des mit Wasserstoff behandelten Bauteils nur geringfügig kleiner als die aufgenommene Energie des Bauteils, welches nicht mit Wasserstoff behandelt wurde. In anderen Worten ist durch den Wasserstoff keine oder allenfalls eine geringe Versprödung eingetreten.

In der **Figur** 3 ist ein weiteres Zug-Dehnungsdiagramm eines Versuchs gezeigt, wobei die für den Versuch verwendeten Bauteile nicht der Erfindung entsprachen. Wie der Figur 3 entnommen werden kann, ist die von dem mit Wasserstoff behandelten Bauteil aufgenommene plastische Energie deutlich geringer als diejenige des Bauteils, welche nicht mit Wasserstoff behandelt wurde. In den Figuren 2 und 3 gezeigten Diagrammen ist der Bruch des Bauteils mit Wasserstoffbehandlung bzw. das Versagen jeweils mit einem Stern gekennzeichnet. Der Bruch des Bauteils, welches nicht mit Wasserstoff behandelt wurde ist jeweils mit einem Kreuz gekennzeichnet. In den Figuren 2 und 3 sind dabei die gleichen Skalen verwendet worden, um einen Vergleich zu ermöglichen.

**Patentansprüche**

**1.** Bauteil mit einem Bestandteil (1) aus Stahl,

wobei das Bauteil ein Befestigungsmittel ist,
wobei der Bestandteil (1) einen Gewindebereich und/oder Schaftbereich aufweist und/oder ausbildet,

wobei der Bestandteil (1) zumindest teilweise, insbesondere im Gewindebereich und/oder Schaftbereich, mit einer Nickeldiffusionsschicht (10) beschichtet ist,
wobei die Schichtdicke der Nickeldiffusionsschicht (10) 5 - 300 $\mu$m beträgt,
wobei die Nickeldiffusionsschicht (10) einen Nickelanteil aufweist, bezogen auf das Gesamtgewicht der Nickeldiffusionsschicht, von 2 Gew.-% über dem Nickelanteil des Stahls bis zu einer Maximalkonzentration,
wobei der Nickelanteil in der Nickeldiffusionsschicht (10) in Richtung Oberfläche (12) der Nickeldiffusionsschicht (10) kontinuierlich von 2 Gew.-% über dem Nickelanteil des Stahls bis zur Maximalkonzentration zunimmt, und
wobei die Maximalkonzentration 20 - 100 Gew.-% beträgt, wobei die Schichtdicke der Nickeldiffusionsschicht (10) und der Nickelanteil gemäß der vorliegenden Beschreibung gemessen werden.

2. Bauteil nach Anspruch 1, **dadurch gekennzeichnet, dass** die Maximalkonzentration 70 - 99,5 Gew.-%, bevorzugt 80 - 99,2 Gew.-%, beträgt.

3. Bauteil nach einem der vorhergehenden Ansprüche, **dadurch gekennzeichnet, dass** der Nickelanteil in der Nickeldiffusionsschicht (10) senkrecht in Richtung Oberfläche (12) der Nickeldiffusionsschicht (10) zunimmt.

4. Bauteil nach einem der vorhergehenden Ansprüche, **dadurch gekennzeichnet, dass** auf der Nickeldiffusionsschicht (10) eine weitere Schicht aufgebracht ist, ausgewählt aus Nickelschicht, umfassend $\geq$ 90 Gew.-% Nickel, bezogen auf das Gesamtgewicht der Nickelschicht, Korrosionsschutzschicht, Verschleißschutzschicht und Gleitschicht.

5. Bauteil nach einem der vorhergehenden Ansprüche, **dadurch gekennzeichnet, dass** der Stahl ein niedriglegierter Stahl, ein mikrolegierter Stahl oder ein unlegierter Stahl ist.

6. Bauteil nach einem der vorhergehenden Ansprüche, **dadurch gekennzeichnet, dass** das Bauteil ausgewählt ist aus der Gruppe bestehend aus hochfesten und ultrahochfesten Bauteilen, geschweißten Bauteilen, additiv-gefertigten Bauteilen, umgeformten Bauteilen und/oder einsatzgehärteten Bauteilen.

7. Bauteil nach einem der vorhergehenden Ansprüche, **dadurch gekennzeichnet, dass** das Bauteil ein hochfestes oder ultrahochfestes Bauteil ist, gewählt aus der Gruppe bestehend aus Schrauben, Federn, Blattfedern, Tellerfedern und Kettenantrieben.

8. Verwendung eines Bauteils gemäß einem der Ansprüche 1 bis 7 zur Verminderung einer Wasserstoffversprödung, insbesondere Verwendung in einer Batterieanordnung und/oder einer Brennstoffzelle.

9. Batterieanordnung oder Brennstoffzelle, umfassend ein Befestigungsmittel, gemäß einem der Ansprüche 1 bis 7.

**Claims**

1. Component with a steel constituent (1),

   where the component is a fastener,
   wherein the component (1) has and/or forms a threaded area and/or shank area,
   wherein the component (1) is at least partially coated with a nickel diffusion layer (10), in particular in the threaded area and/or shank area,
   wherein the layer thickness of the nickel diffusion layer (10) is 5 - 300 $\mu$m,
   wherein the nickel diffusion layer (10) has a nickel content, based on the total weight of the nickel diffusion layer, of 2 wt.-% above the nickel content of the steel up to a maximum concentration,
   wherein the nickel content in the nickel diffusion layer (10) increases continuously in the direction of the surface (12) of the nickel diffusion layer (10) from 2 wt.-% above the nickel content of the steel to the maximum concentration, and
   wherein the maximum concentration is 20 - 100 wt.-%, wherein the layer thickness of the nickel diffusion layer (10) and the nickel content are measured according to the present description.

2. Component according to claim 1, **characterized in that** the maximum concentration is 70 - 99.5 wt.-%, preferably 80 - 99.2 wt.-%.

3. Component according to any one of the preceding claims, **characterized in that** the nickel content in the nickel diffusion layer (10) increases perpendicularly in the direction of the surface (12) of the nickel diffusion layer (10).

4. Component according to any one of the preceding claims, **characterized in that** a further layer is applied to the nickel diffusion layer (10), selected from nickel layer comprising ≥ 90 wt.-% nickel, based on the total weight of the nickel layer, corrosion protection layer, wear protection layer and sliding layer.

5. Component according to any one of the preceding claims, **characterized in that** the steel is a low-alloy steel, a micro-alloy steel or an unalloyed steel.

6. Component according to any one of the preceding claims, **characterized in that** the component is selected from the group consisting of high-strength and ultra-high-strength components, welded components, additive-manufactured components, formed components and/or case-hardened components.

7. Component according to any one of the preceding claims, **characterized in that** the component is a high-strength or ultra-high-strength component selected from the group consisting of screws, springs, leaf springs, disc springs and chain drives.

8. Use of a component according to any one of claims 1 to 7 for reducing hydrogen embrittlement, in particular use in a battery arrangement and/or a fuel cell.

9. Battery arrangement or fuel cell comprising a mounting means according to any one of claims 1 to 7.


**Revendications**

1. Pièce comprenant un composant (1) en acier,

   la pièce étant un moyen de fixation,
   le composant (1) présentant et/ou constituant une zone filetée et/ou une zone de tige,
   le composant (1) étant revêtu au moins partiellement, en particulier dans la zone filetée et/ou dans la zone de tige, d'une couche de diffusion de nickel (10),
   l'épaisseur de la couche de diffusion de nickel (10) étant de 5 à 300 μm,
   la couche de diffusion de nickel (10) présentant une proportion de nickel qui, par rapport au poids total de la couche de diffusion de nickel, est supérieure de 2 % en poids à la proportion de nickel de l'acier, jusqu'à une concentration maximale,
   la proportion de nickel dans la couche de diffusion de nickel (10) augmentant en continu, en direction de la surface (12) de la couche de diffusion de nickel (10), pour passer d'une valeur supérieure de 2 % en poids à la proportion de nickel de l'acier jusqu'à la concentration maximale, et
   la concentration maximale étant de 20 à 100 % en poids,
   l'épaisseur de la couche de diffusion de nickel (10) et la proportion de nickel étant mesurées conformément à la description.

2. Pièce selon la revendication 1, **caractérisée en ce que** la concentration maximale est de 70 à 99,5 % en poids, de préférence de 80 à 99,2 % en poids.

3. Pièce selon l'une des revendications précédentes, **caractérisée en ce que** la proportion de nickel dans la couche de diffusion de nickel (10) augmente perpendiculairement en direction de la surface (12) de la couche de diffusion de nickel (10).

4. Pièce selon l'une des revendications précédentes, **caractérisée en ce qu'**une autre couche est appliquée sur la couche de diffusion de nickel (10), qui est choisie parmi une couche de nickel, comprenant ≥ 90 % en poids de nickel, par rapport au poids total de la couche de nickel, une couche de protection contre la corrosion, une couche de protection contre l'usure et une couche de glissement.

5. Pièce selon l'une des revendications précédentes, **caractérisée en ce que** l'acier est un acier faiblement allié, un acier micro-allié ou un acier non allié.

6. Pièce selon l'une des revendications précédentes, **caractérisée en ce que** la pièce est choisie dans le groupe constitué par les pièces à haute résistance et à ultra-haute résistance, les pièces soudées, les pièces fabriquées par fabrication additive, les pièces mises en forme et/ou les pièces cémentées.

7. Pièce selon l'une des revendications précédentes, **caractérisée en ce que** la pièce est une pièce à haute résistance ou à ultra-haute résistance choisie dans le groupe constitué par les vis, les ressorts, les ressorts à lames, les rondelles-ressorts et les transmissions par chaîne.

8. Utilisation d'une pièce selon l'une des revendications 1 à 7 pour réduire une fragilisation par l'hydrogène, en particulier, utilisation dans un ensemble de batterie et/ou dans une pile à combustible.

9. Ensemble de batterie ou pile à combustible, comprenant un moyen de fixation selon l'une des revendications 1 à 7.

**Fig. 1**

**Fig. 2**

**Fig. 3**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20160168657 A1